# EUROPÄISCHE PATENTANMELDUNG

(11) **EP 3 355 347 A1**
(43) Veröffentlichungstag der Anmeldung: **01.08.2018**
(21) Anmeldenummer: 17153983.6
(22) Anmeldetag: 31.01.2017
(51) Int. Cl.: H01L 23/051, H01L 23/538

(54) **KONTAKTIERUNGSVORRICHTUNG EINES LEISTUNGSHALBLEITER**

(71) Anmelder: Siemens Aktiengesellschaft, 80333 München (DE)
(72) Erfinder: Gläser, Thomas, 91341 Röttenbach (DE)

(57) **Zusammenfassung**

Die Erfindung betrifft eine Kontaktierungsvorrichtung (1) zur elektrischen Kontaktierung eines Leistungshalbleiters (2) mit einem Trägerelement (6), wobei die Kontaktierungsvorrichtung (1) derart ausgebildet ist, dass sie den Leistungshalbleiter (2) zumindest teilweise begrenzen kann, wobei die Kontaktierungsvorrichtung (1) an einer ersten Seite (3) eine erste Kontakteinheit (4) zur elektrischen Verbindung mit dem Leistungshalbleiter (2) aufweist, wobei die Kontaktierungsvorrichtung (1) an einer zweiten Seite (5), welche der ersten Seite (3) abgewandt ist, mit dem Trägerelement (6) mechanisch verbindbar ist, wobei die Kontaktierungsvorrichtung (1) eine zweite Kontakteinheit (7) zur elektrischen Verbindung mit dem Trägerelement (6) aufweist und wobei die erste Kontakteinheit (4) mit der zweiten Kontakteinheit (7) elektrisch verbunden ist. Ferner betrifft die Erfindung eine elektronische Baugruppe (14) mit der Kontaktierungsvorrichtung (1) und eine Serie von elektronischen Baugruppen (14).

## Beschreibung

Die Erfindung betrifft eine Kontaktierungsvorrichtung zur elektrischen Kontaktierung eines Leistungshalbleiters mit einem Trägerelement, eine elektronische Baugruppe mit der Kontaktierungsvorrichtung und eine Serie von elektronischen Baugruppen.

Elektronische Bauelemente, welche beispielsweise einzeln als Leistungshalbleiter zum Schalten von elektrischer Energie in Stromrichtern der Antriebstechnik oder der Energieversorgung zum Einsatz kommen, können direkt in elektronische Schaltkreise auf Trägerelementen, wie z.B. Leiterplatten, montiert und bestimmungsgemäß betrieben werden. Im Unterschied dazu können in einem elektronischen Modul integrierte elektronische Bauelemente, wie beispielsweise Leistungshalbleiter in einem Leistungshalbleitermodul für Brückenschaltungen, nur als Bestandteil des elektronischen Moduls montiert und bestimmungsgemäß betrieben werden.

Die einzelnen Leistungshalbleiter sind dabei oftmals derart ausgelegt, dass sowohl deren Oberseite wie auch Unterseite elektrisch kontaktiert werden muss. Insbesondere bei Leistungshalbleitermodulen mit integrierten Leistungshalbleitern wird hingegen meist nur eine der beiden Seiten des jeweiligen Leistungshalbleitermoduls mit dem elektronischen Schaltkreis elektrisch verbunden, wobei die andere Seite oft nur zur mechanischen Verbindung mit einem entsprechenden Trägerelement, meist in Kombination mit einer Kühlvorrichtung, vorgesehen ist.

Die elektrische Kontaktierung von Leistungshalbleitern erfordert insbesondere für schnelle Schalthandlungen der hochfrequent getakteten Leistungshalbleiter sehr niederinduktive elektrische Verbindungen. Ein Problem für die elektrische Kontaktierung des an der Oberseite und der Unterseite zu kontaktierenden einzelnen Leistungshalbleiters mit einer herkömmlichen planen Leiterplatte ist die im Gegensatz zur elektrischen Verbindung der Unterseite höherinduktive elektrische Verbindung der von der planen Leiterplatte abgewandten Oberseite des Leistungshalbleiters.

Um dieses Problem zu umgehen, kommt derzeit eine bekannte Lösung zum Einsatz, bei denen einzelne elektronische Bauelemente, wie die einzelnen Leistungshalbleiter, in eine vorbearbeitete Kavität der Leiterplatte eingebracht werden. Die Leiterplatte weist dabei meist eine Schichtstruktur mit elektrischen Verbindungen auf, mittels derer sowohl die Unterseite wie auch die Oberseite der einzelnen Leistungshalbleiter niederinduktiv kontaktierbar ist.

Der Nachteil der genannten Lösung ist jedoch, dass herkömmliche, in hohen Stückzahlen für verschiedenste Anwendungsbereiche gefertigte und daher meist auch betriebswirtschaftlich günstig verfügbare, plane Leiterplatten für diese elektrische Kontaktierung so nicht verwendet werden können. Die Leiterplatten, in welche dann entsprechende Kavitäten eingebracht sind, werden je nach Anwendungsfall und daher eher in vergleichsweise geringer Stückzahl hergestellt, was in der Regel betriebswirtschaftlich ineffizient ist. Auch ist eine Nachbearbeitung von herkömmlichen planen Leiterplatten, falls überhaupt möglich, bearbeitungstechnisch mit in der Regel hohem Herstellungsaufwand verbunden, was betriebswirtschaftlich eher auch ineffizient ist.

Der Erfindung liegt nunmehr die Aufgabe zugrunde, eine Kontaktierungsvorrichtung bereitzustellen, welche eine oder mehrere elektrische Verbindungen zur niederinduktiven Kontaktierung von Leistungshalbleitern mit herkömmlichen, für eine Vielzahl von Anwendungsfällen geeigneten Trägerelementen verbessert.

Die Aufgabe wird durch eine Kontaktierungsvorrichtung mit den in Anspruch 1 angegebenen Merkmalen gelöst.

Ferner wird die Aufgabe durch eine elektronische Baugruppe nach Anspruch 7 und durch eine Serie von elektronischen Baugruppen nach Anspruch 15 gelöst.

Der Erfindung liegt die Erkenntnis zugrunde, dass für eine niederinduktive elektrische Kontaktierung der Oberseite eines einzelnen elektronischen Bauelements, wie das eines einzelnen Leistungshalbleiters, mit einem von dessen Oberseite abgewandten Trägerelements eine Art von Adapter benötigt wird, welcher eine Reduktion des Abstands eines oder mehrerer elektrischer Leiter des Trägerelements zu einem oder mehreren elektrischen Kontakten des Leistungshalbleiters herstellt, wobei in Folge der Reduktion und im gemeinsamen Betrieb mit dem Leistungshalbleiter die gewünschte niederinduktive elektrische Kontaktierung erzeugbar ist.

Für die Lösung der Aufgabe wird eine Kontaktierungsvorrichtung zur elektrischen Kontaktierung eines Leistungshalbleiters mit einem Trägerelement vorgeschlagen, wobei die Kontaktierungsvorrichtung derart ausgebildet ist, dass sie den Leistungshalbleiter zumindest teilweise begrenzen kann, wobei die Kontaktierungsvorrichtung an einer ersten Seite eine erste Kontakteinheit zur elektrischen Verbindung mit dem Leistungshalbleiter aufweist, wobei die Kontaktierungsvorrichtung an einer zweiten Seite, welche der ersten Seite abgewandt ist, mit dem Trägerelement mechanisch verbindbar ist, wobei die Kontaktierungsvorrichtung eine zweite Kontakteinheit zur elektrischen Verbindung mit dem Trägerelement aufweist und wobei die erste Kontakteinheit mit der zweiten Kontakteinheit elektrisch verbunden ist.

Mittels der Kontaktierungsvorrichtung kann der Leistungshalbleiter sowohl an seiner ersten Seite, welche im montierten Zustand im Allgemeinen der Oberseite des Leistungshalbleiters entspricht, über die erste Kontakteinheit, wie auch an seiner zweiten Seite, welche im montierten Zustand im Allgemeinen der Unterseite des Leistungshalbleiters entspricht, über die zweite Kontakteinheit, in vorteilhafter Weise elektrisch niederinduktiv mit einem von mehreren Kontakten, beispielsweise dem Gate-Kontakt oder dem Source-Kontakt oder dem Drain-Kontakt, verbunden werden.

Vom Prinzip her ist die Kontaktierungsvorrichtung geeignet, verschiedenste Typen von elektronischen Bauelementen mit einem Trägerelement zu kontaktieren, soweit eine Oberseite und Unterseite des elektronischen Bauelements wie, bezogen auf den Leistungshalbleiter, bereits aufgezeigt, elektrisch kontaktiert werden sollen und die Kontaktierungsvorrichtung sowie das elektronische Bauelement für eine mechanische Verbindung mit dem Trägerelement vorgesehen sind.

Die erste und die zweite Kontakteinheit mit deren elektrischen Verbindungen weisen in der Regel ein sehr gut elektrisch leitendes Material, wie zum Beispiel Kupfer, auf, wobei darüber hinaus auch eine im gemeinsamen Betrieb mit dem Leistungshalbleiter auftretende Entwärmung der Verlustwärme des Leistungshalbleiters vorgesehen sein kann.

Als Basismaterial, welches einerseits der Kontaktierungsvorrichtung sein geometrisches Abmaß und dadurch seine Form gibt, andererseits die erste und die zweite Kontakteinheit mit deren elektrischen Verbindungen aufnimmt, kommt vorzugsweise bekanntes Leiterplattenmaterial aus zum Beispiel in Epoxidharz getränktem Glasgewebe zum Einsatz, auch Prepreg (Preimregnated) genannt, welches bei Bedarf in einem gemeinsamen Schichtaufbau mindestens eine elektrische Leiterbahn, auch Kern genannt (meist bestehend aus kupferkaschiertem Material), enthalten kann.

Vorteilhafte Ausgestaltungsformen der Kontaktierungsvorrichtung sind in den abhängigen Ansprüchen angegeben.

Bei einer ersten vorteilhaften Ausgestaltungsform der erfindungsgemäßen Kontaktierungsvorrichtung ist die zweite Kontakteinheit an der zweiten Seite angeordnet und ist die elektrische Verbindung zwischen der ersten Kontakteinheit und der zweiten Kontakteinheit mittels mindestens einer elektrischen Durchkontaktierung ausgebildet.

Die elektrische Durchkontaktierung bildet eine gewünschte kurze Strecke für die elektrische Verbindung zwischen der ersten Kontakteinheit und der zweiten Kontakteinheit. Dies unterstützt in vorteilhafter Weise die Bildung der niederinduktiven elektrischen Kontaktierung des Leistungshalbleiters mit dem Trägerelement.

Mehrere elektrische Durchkontaktierungen für die elektrische Verbindung der ersten und der zweiten Kontakteinheit verbessern ferner einerseits die elektrische und andererseits die thermische Leitfähigkeit dieser elektrischen Verbindung.

Bei einer weiteren vorteilhaften Ausgestaltungsform der erfindungsgemäßen Kontaktierungsvorrichtung ist die zweite Kontakteinheit auf der ersten Seite der Kontaktierungsvorrichtung angeordnet und ist die zweite Kontakteinheit mit der ersten Kontakteinheit elektrisch leitend verbunden.

Vorzugsweise wird die zweite Kontakteinheit durch die erste Kontakteinheit ausgebildet. Mit dieser Ausgestaltungsform kann das Trägerelement mit der ersten Seite der Kontaktierungsvorrichtung direkt elektrisch verbunden werden.

Denkbar ist jedoch auch, dass ein oder mehrere elektronische Komponenten bzw. ein oder mehrere elektronische Bauelemente mittels der elektrischen Verbindung zwischen dem Trägerelement und der ersten Seite der Kontaktierungsvorrichtung verbunden sein können, was eine Kombinatorik der Anordnung von elektronischen Komponenten bzw. Bauelementen, welche über die Kontaktierungsvorrichtung mit dem Leistungshalbleiter kontaktiert werden sollen, verbessert.

Bei einer weiteren vorteilhaften Ausgestaltungsform der erfindungsgemäßen Kontaktierungsvorrichtung weist die Kontaktierungsvorrichtung eine dritte Kontakteinheit, welche von der ersten Kontakteinheit elektrisch isoliert ist, zur elektrischen Verbindung mit dem Leistungshalbleiter auf, weist die Kontaktierungsvorrichtung eine vierte Kontakteinheit, welche von der zweiten Kontakteinheit elektrisch isoliert ist, zur elektrischen Verbindung mit dem Trägerelement auf und ist die dritte Kontakteinheit mit der vierten Kontakteinheit elektrisch verbunden.

Mittels der dritten und der vierten Kontakteinheit kann in vorteilhafter Weise eine weitere elektrische Verbindung zwischen dem Trägerelement und dem Leistungshalbleiter erzeugt werden, wobei die weitere elektrische Verbindung potentialgetrennt zur elektrischen Verbindung der ersten und zweiten Kontakteinheit ist. Darüber hinaus können zusätzliche elektrische Verbindungen zwischen zusätzlichen Kontakteinheiten der Kontaktierungsvorrichtung vorgesehen werden, welche dann zusätzliche elektrische Kontaktierungen des Trägerelements mit dem Leistungshalbleiter bilden können.

Vorzugsweise werden die weitere elektrische Verbindung zwischen der dritten Kontakteinheit und der vierten Kontakteinheit bzw. die zusätzlichen elektrischen Verbindungen zwischen zusätzlichen Kontakteinheiten mittels jeweils mindestens einer weiteren elektrischen Durchkontaktierung ausgebildet.

Bei einer weiteren vorteilhaften Ausgestaltungsform der erfindungsgemäßen Kontaktierungsvorrichtung weist die erste Seite der Kontaktierungsvorrichtung zumindest teilweise eine erste Kupferkaschierung zur mechanischen Befestigung mit einer Abdeckplatte auf und/oder weist die zweite Seite der Kontaktierungsvorrichtung zumindest teilweise eine zweite Kupferkaschierung zur mechanischen Befestigung mit dem Trägerelement auf.

Vorzugsweise sind die erste Kupferkaschierung der ersten Seite der Kontaktierungsvorrichtung und die zweite Kupferkaschierung der zweiten Seite der Kontaktierungsvorrichtung jeweils potentialgetrennt von, falls vorhanden, der im Schichtaufbau der Kontaktierungsvorrichtung vorgesehenen mindestens einen elektrischen Leiterbahn.

Bei einer weiteren vorteilhaften Ausgestaltungsform der erfindungsgemäßen Kontaktierungsvorrichtung weist die Kontaktierungsvorrichtung eine O-Form, eine U-Form, eine L-Form oder eine I-Form zur Begrenzung des Leistungshalbleiters von der Kontaktierungsvorrichtung auf.

Zur Begrenzung der Leistungshalbleiter durch die Kontaktierungsvorrichtung kann auch eine Doppel-I-Form vorgesehen sein, wobei die Doppel-I-Form dann in vorteilhafter Weise mittels zweier I-Formen ausgebildet ist und der Leistungshalbleiter zwischen den beiden I-Formen anordenbar ist.

Für die Lösung der Aufgabe wird weiterhin eine elektronische Baugruppe vorgeschlagen, welche eine erfindungsgemäße Kontaktierungsvorrichtung, den Leistungshalbleiter und das Trägerelement aufweist, wobei die Kontaktierungsvorrichtung den Leistungshalbleiter zumindest teilweise begrenzt, wobei die Kontaktierungsvorrichtung an der ersten Seite mittels der ersten Kontakteinheit mit dem Leistungshalbleiter elektrisch verbunden ist, wobei die Kontaktierungsvorrichtung an der zweiten Seite mit dem Trägerelement mechanisch verbunden ist und wobei die Kontaktierungsvorrichtung mittels der zweiten Kontakteinheit mit dem Trägerelement elektrisch verbunden ist.

Der kürzeste Abstand zur Erzielung einer besonders vorteilhaften niederinduktiven Kontaktierung mittels der elektrischen Verbindung zwischen der ersten Kontakteinheit der Kontaktierungsvorrichtung und einem von mehreren Kontakten des Leistungshalbleiters, beispielsweise dem Gate-Kontakt, dem Source-Kontakt oder dem Drain-Kontakt, ist eine direkte und auf die kürzeste Strecke gerichtete elektrische Verbindung zwischen der ersten Kontakteinheit über die Begrenzung hinweg zu dem einem von mehreren Kontakten des Leistungshalbleiters, welcher kontaktiert werden soll.

Bei einer ersten vorteilhaften Ausgestaltungsform der erfindungsgemäßen elektronischen Baugruppe ist die Kontaktierungsvorrichtung an der ersten Seite mittels der dritten Kontakteinheit mit dem Leistungshalbleiter elektrisch verbunden und ist die Kontaktierungsvorrichtung mittels der vierten Kontakteinheit mit dem Trägerelement elektrisch verbunden.

Bei einer weiteren vorteilhaften Ausgestaltungsform der erfindungsgemäßen elektronischen Baugruppe weist die elektronische Baugruppe die Abdeckplatte auf, welche mit der ersten Seite der Kontaktierungsvorrichtung zumindest mechanisch verbunden ist.

Die Abdeckplatte verringert oder verhindert in vorteilhafter Weise eine auf den Leistungshalbleiter einwirkende unerwünschte mechanische Belastung, erzeugt für den Leistungshalbleiter eine isolierende Wirkung als Schutz vor flüssigen und/oder gasförmigen Medien und isoliert den Leistungshalbleiter im Betrieb elektrisch von einem für ihn unvorhergesehenen betriebsgefährdenden elektrischen Potential.

Als Material für die Abdeckplatte wird vorzugsweise Keramik vorgeschlagen, wobei die Abdeckplatte auch aus Schichten verschiedener Materialien bestehen kann, welche die im vorangegangenen Absatz beschriebenen schützenden Merkmale für den Leistungshalbleiter verbessern. Eine weitere Schutzfunktion in Form einer elektromagnetischen Abschirmung des Leistungshalbleiters nach außen oder innen kann mittels Einbringung von abschirmenden Materialen, wie Ferriten, in die Schichten erfolgen.

Bei einer weiteren vorteilhaften Ausgestaltungsform der erfindungsgemäßen elektronischen Baugruppe ist die erste Kontakteinheit mit dem Leistungshalbleiter über die Abdeckplatte mittels eines ersten elektrischen Anschlussmittels elektrisch verbunden und/oder, sofern die dritte Kontakteinheit vorhanden ist, ist die dritte Kontakteinheit mit dem Leistungshalbleiter über die Abdeckplatte mittels eines zweiten elektrischen Anschlussmittels elektrisch verbunden.

Das erste elektrische Anschlussmittel zwischen der ersten Kontakteinheit und einem von mehreren Kontakten des Leistungshalbleiters und/oder, sofern die dritte Kontakteinheit vorhanden ist, das zweite elektrische Anschlussmittel zwischen der dritten Kontakteinheit und einem weiteren von mehreren Kontakten des Leistungshalbleiters ist jeweils vorzugsweise mittels mindestens eines Bonddrahts ausgebildet.

Die elektrische Verbindung zwischen der zweiten Kontakteinheit und einer Leiterbahn des Trägerelements und/oder, sofern die vierte Kontakteinheit vorhanden ist, die elektrische Verbindung zwischen der vierten Kontakteinheit und einer weiteren Leiterbahn des Trägerelements ist jeweils mittels mindestens einer Lötverbindung oder mindestens einer Sinterverbindung ausgebildet.

Bei einer weiteren vorteilhaften Ausgestaltungsform der erfindungsgemäßen elektronischen Baugruppe steht der Leistungshalbleiter entlang der Begrenzung durch die Kontaktierungsvorrichtung in einem unmittelbaren mechanischen Kontakt mit der Kontaktierungsvorrichtung.

Dies verbessert die gewünschten niederinduktiven Eigenschaften der elektrischen Verbindung des Leistungshalbleiters über die Kontaktierungsvorrichtung mit dem Trägerelement weiter in vorteilhafter Weise.

Bei einer weiteren vorteilhaften Ausgestaltungsform der erfindungsgemäßen elektronischen Baugruppe ist entlang der Begrenzung des Leistungshalbleiters durch die Kontaktierungsvorrichtung ein Zwischenraum zwischen Kontaktierungsvorrichtung und Leistungshalbleiter gebildet und ist der Zwischenraum vorzugsweise mittels eines thermisch leitfähigen und/oder elektrisch isolierenden Füllstoffs ausgefüllt.

Bei einer weiteren vorteilhaften Ausgestaltungsform der erfindungsgemäßen elektronischen Baugruppe wird als Trägerelement ein planes Trägerelement ohne Ausbuchtung und/oder Einbuchtung für den Leistungshalbleiter verwendet.

Bei einer weiteren vorteilhaften Ausgestaltungsform der erfindungsgemäßen elektronischen Baugruppe entspricht die Höhe der Kontaktierungsvorrichtung zumindest 80% der Höhe des Leistungshalbleiters.

Mittels dieser Ausgestaltungsform ist die verbesserte niederinduktive Eigenschaft der elektrischen Kontaktierung des Trägerelements mit dem Leistungshalbleiter auch dann gegeben, wenn die Kontaktierungsvorrichtung eine Toleranz ihrer Höhe entgegen der Höhe des Leistungshalbleiters aufweist, unabhängig davon, ob diese Toleranz ergibt, dass die Höhe der Kontaktierungsvorrichtung um bis zu 20% kleiner ist als die Höhe des Leistungshalbleiters.

Vorzugsweise entspricht die Höhe der Kontaktierungsvorrichtung mindestens der Höhe des Leistungshalbleiters. Der Vorteil ist, dass, falls vorhanden, der Zwischenraum zwischen Leistungshalbleiter und Kontaktierungsvorrichtung annähernd vollständig bis zur Höhe des Leistungshalbleiters oder, bei einer höheren Kontaktierungsvorrichtung gegenüber dem Leistungshalbleiter auch darüber hinaus, mit dem thermisch leitfähigen und/oder elektrisch isolierenden Füllstoff vergossen werden kann.

Für die Lösung der Aufgabe wird ebenfalls eine Serie von elektronischen Baugruppen vorgeschlagen, welche ein erstes elektronisches Baugruppenserienelement mit einem Leistungshalbleiter einer ersten geometrischen Dimensionierung und ein zweites elektronisches Baugruppenserienelement mit einem zweiten Leistungshalbleiter einer zweiten geometrischen Dimensionierung umfassen, wobei die zweite geometrische Dimensionierung unterschiedlich zur ersten geometrischen Dimensionierung ist, wobei das erste elektronische Baugruppenserienelement eine erfindungsgemäße elektronische Baugruppe ist, deren Kontaktierungsvorrichtung an den Leistungshalbleiter der ersten geometrischen Dimensionierung angepasst ist, wobei das zweite elektronische Baugruppenserienelement eine erfindungsgemäße elektronische Baugruppe ist, deren Kontaktierungsvorrichtung an den Leistungshalbleiter der zweiten geometrische Dimensionierung angepasst ist und wobei für das erste und das zweite elektronische Baugruppenserienelement jeweils als Trägerelement ein planes Trägerelement ohne Ausbuchtung und/oder Einbuchtung für die Leistungshalbleiter verwendet wird.

Mit der Serie von elektronischen Baugruppen können in vorteilhafter Weise für Leistungshalbleiter mit unterschiedlichen geometrischen Dimensionen, wie sie von verschiedenen Herstellern angeboten werden, jeweils abgestimmt ausgelegte Kontaktierungsvorrichtungen zum Einsatz kommen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
FIG 1 eine erste schematische Darstellung der erfindungsgemäßen Kontaktierungsvorrichtung in einer O-Form,
FIG 2 eine weitere schematische Darstellung der erfindungsgemäßen Kontaktierungsvorrichtung nach FIG 1 in einer U-Form,
FIG 3 eine weitere schematische Darstellung der erfindungsgemäßen Kontaktierungsvorrichtung nach FIG 1 in einer L-Form,
FIG 4 eine weitere schematische Darstellung der erfindungsgemäßen Kontaktierungsvorrichtung nach FIG 1 in einer I-Form und
FIG 5 eine schematische Querschnittdarstellung einer elektronischen Baugruppe mit der erfindungsgemäßen Kontaktierungsvorrichtung nach FIG 1.

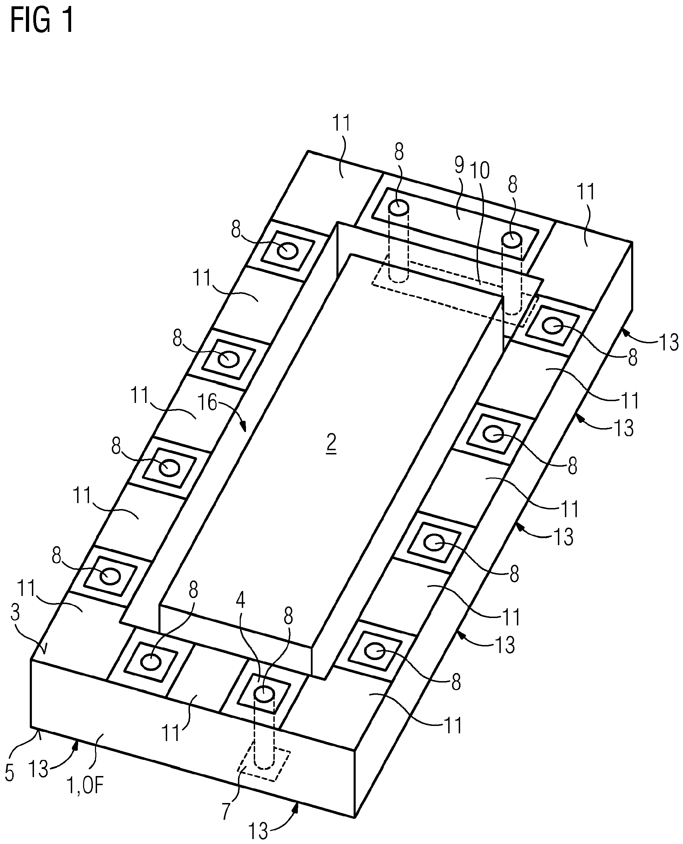

Die FIG 1 zeigt eine erfindungsgemäße Kontaktierungsvorrichtung (1) in einer O-Form (OF), welche einen Leistungshalbleiter (2) an vier seiner Seiten begrenzt, jedoch nicht an der Seite der Draufsicht des Leistungshalbleiters (2), also dessen Oberseite, und nicht an der von der Seite der Draufsicht abgewandten Seite des Leistungshalbleiters (2), also dessen Unterseite. Zwischen der Kontaktierungsvorrichtung (1) und dem Leistungshalbleiter (2) ist ein Zwischenraum (16) gebildet, welcher mittels eines thermisch leitfähigen und/oder elektrisch isolierenden Füllstoffs ausfüllbar ist.

Die Kontaktierungsvorrichtung (1) bildet demnach einen Rahmen um den Leistungshalbleiter (2), wobei die Kontaktierungsvorrichtung (1) und der Leistungshalbleiter (2) zumindest annähernd die gleiche Höhe aufweisen. Während eine erste Seite (3) der Kontaktierungsvorrichtung (1) - in FIG 1 ist dies die Draufsicht, also die Oberseite der Kontaktierungsvorrichtung(1) - eine erste Kupferkaschierung (11) aufweist, ist auf einer zweiten Seite (5) der Kontaktierungsvorrichtung (1) - in FIG 1 ist dies die von der Draufsicht abgewandte Seite, also die Unterseite der Kontaktierungsvorrichtung (1) - zumindest annähernd deckungsgleich zur ersten Kupferkaschierung (11) eine zweite Kupferkaschierung (13) angeordnet.

Mittels der ersten Kupferkaschierung (11) ist eine zumindest mechanische Verbindung der Kontaktierungsvorrichtung (1) mit einer Abdeckplatte (in FIG 1 nicht gezeigt) erzeugbar, beispielsweise durch eine Lötverbindung oder Sinterverbindung. Im Gegensatz dazu ist mittels der zweiten Kupferkaschierung (13) eine weitere zumindest mechanische Verbindung der Kontaktierungsvorrichtung (1) mit einem Trägerelement (in FIG 1 nicht gezeigt) erzeugbar, beispielsweise durch eine weitere Lötverbindung oder eine weitere Sinterverbindung.

Elektrisch von der ersten Kupferkaschierung (11) isoliert, ist eine erste Kontakteinheit (4) auf der ersten Seite (3) der Kontaktierungsvorrichtung (1) angeordnet. Mittels der ersten Kontakteinheit (4) ist die Kontaktierungsvorrichtung (1) mit einem Kontakt (in FIG 1 nicht gezeigt) des Leistungshalbleiters (2) elektrisch verbindbar.

Die erste Kontakteinheit (4) ist über eine elektrische Durchkontaktierung (8) mit einer zweiten Kontakteinheit (7) elektrisch verbunden, welche auf der zweiten Seite (5) der Kontaktierungsvorrichtung (1) angeordnet ist und elektrisch von der zweiten Kupferkaschierung (13) isoliert ist. Mittels der zweiten Kontakteinheit (7) ist die Kontaktierungsvorrichtung (1) mit einer Leiterbahn des Trägerelements (in FIG 1 nicht gezeigt) elektrisch verbindbar.

Elektrisch von der ersten Kupferkaschierung (11) isoliert, ist eine dritte Kontakteinheit (9) auf der ersten Seite (3) der Kontaktierungsvorrichtung (1) angeordnet. Mittels der dritten Kontakteinheit (9) ist die Kontaktierungsvorrichtung (1) mit einem weiteren Kontakt (in FIG 1 nicht gezeigt) des Leistungshalbleiters (2) elektrisch verbindbar.

Die dritte Kontakteinheit (9) ist in diesem Beispiel der FIG 1 über zwei elektrische Durchkontaktierungen (8) mit einer vierten Kontakteinheit (10) elektrisch verbunden, welche auf der zweiten Seite (5) der Kontaktierungsvorrichtung (1) angeordnet ist und elektrisch von der zweiten Kupferkaschierung (13) isoliert ist. Mittels der vierten Kontakteinheit (10) ist die Kontaktierungsvorrichtung (1) mit einer weiteren Leiterbahn des Trägerelements (in FIG 1 nicht gezeigt) elektrisch verbindbar.

Mittels weiterer in FIG 1 gezeigter elektrischer Durchkontaktierungen (8) und an diesen elektrischen Durchkontaktierungen (8) angeordneter weiterer Kontakteinheiten der Kontaktierungsvorrichtung (1), sind weitere elektrische Verbindungen der Kontaktierungsvorrichtung (1) mit dem Leistungshalbleiter (2) und dem Trägerelement (in FIG 1 nicht gezeigt) herstellbar.

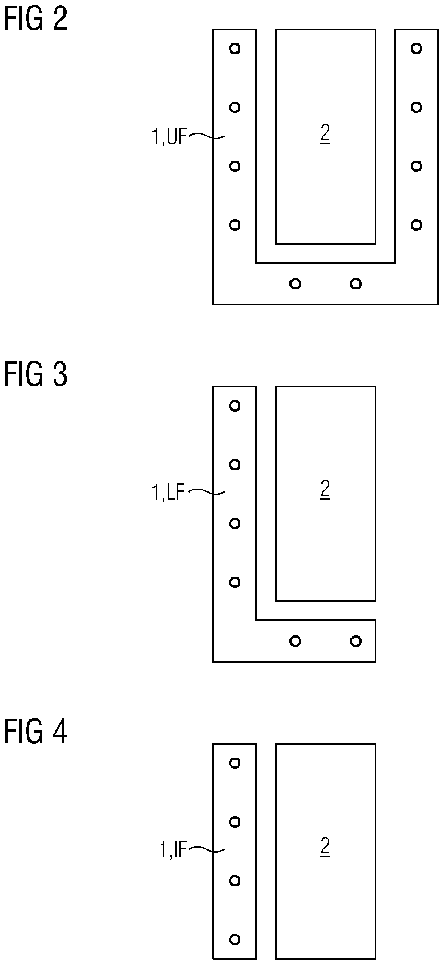

In FIG 2 ist aus der Perspektive der Draufsicht eine U-Form (UF) der Kontaktierungsvorrichtung (1) nach FIG 1 dargestellt, welche den Leistungshalbleiter (2) hier jedoch nur an drei Seiten begrenzt.

Mit FIG 3 wird aus der Perspektive der Draufsicht eine L-Form (LF) der Kontaktierungsvorrichtung (1) nach FIG 1 aufgezeigt, welche den Leistungshalbleiter (2) hier jedoch nur an zwei Seiten begrenzt.

FIG 4 zeigt aus der Perspektive der Draufsicht eine I-Form (IF) der Kontaktierungsvorrichtung (1) nach FIG 1, welche den Leistungshalbleiter (2) hier jedoch nur an einer Seite begrenzt.

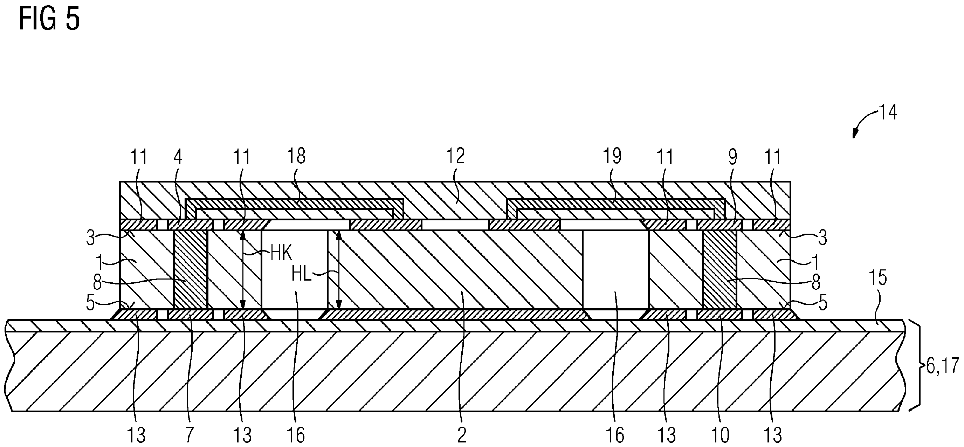

Die FIG 5 zeigt eine schematische Querschnittsdarstellung einer elektronischen Baugruppe (14) mit der erfindungsgemäßen Kontaktierungsvorrichtung (1) nach FIG 1.

Ein Leistungshalbleiter (2) wird aufgrund der Darstellungsart der Querschnittsdarstellung der FIG 5 an zwei seiner Seiten von der Kontaktierungsvorrichtung (1) begrenzt, obwohl die Kontaktierungsvorrichtung nach FIG 1 vier begrenzte Seiten des Leistungshalbleiters zeigt, wovon auch hier beispielhaft auszugehen ist. Zwischen dem Leistungshalbleiter (2) und der Kontaktierungsvorrichtung (1) ist ein Zwischenraum (16) gebildet, welcher mittels eines thermisch leitfähigen und/oder elektrisch isolierenden Füllstoffs ausfüllbar ist.

Die Höhe (HK) der Kontaktierungsvorrichtung (1) ist im Beispiel gleich der Höhe (HL) des Leistungshalbleiters (2).

Die Kontaktierungsvorrichtung (1) ist an einer zweiten Seite (5) der Kontaktierungsvorrichtung (1) mittels einer zweiten Kupferkaschierung (13) über eine Kupferlage (15) des Trägerelements (6) mit dem Trägerelement (6), welches als planes Trägerelement (17) ausgeführt ist, zumindest mechanisch verbunden.

Mittels einer zweiten Kontakteinheit (7) sowie einer vierten Kontakteinheit (10) ist die Kontaktierungsvorrichtung (1) mit der Kupferlage (15) des planen Trägerelements (6,17) und darin eingebrachten elektrischen Leiterbahnen (in FIG 5 nicht gezeigt) elektrisch verbunden.

Ebenfalls mechanisch aber - in FIG 5 nicht detaillierter dargestellt - in der Regel auch elektrisch ist der Leistungshalbleiter (2) an seiner Unterseite, welche auf der gleichen Ebene wie die zweite Seite (5) der Kontaktierungsvorrichtung (1) angeordnet ist, mit der Kupferlage (15) und darin eingebrachten Leiterbahnen (in FIG 5 nicht dargestellt) des planen Trägerelements (6,17) verbunden.

Eine genauere Darstellung von elektrischen Abgrenzung/Isolierungen elektrischer Leiterbahnen in der Kupferlage (15) des planen Trägerelements (6,17) ist in Bezug auf deren elektrischen Verbindungen mit dem Leistungshalbleiter (2) mit der gewählten Darstellungsform der Querschnittsdarstellung in FIG 5 nicht möglich, so dass hier elektrisch fehlerfreie Kontaktierungen mit den entsprechend ausgelegten Leiterbahnen der Kupferlage (15) des planen Trägerelements (6,17) vorausgesetzt werden.

An einer ersten Seite (3) der Kontaktierungsvorrichtung (1) ist die Kontaktierungsvorrichtung (1) mittels einer ersten Kupferkaschierung (11) zumindest mechanisch mit einer Abdeckplatte (12) verbunden, wobei die Abdeckplatte (12) den Leistungshalbleiter (2) hier übergreift und somit gemeinsam mit der Kontaktierungsvorrichtung (1) und dem planen Trägerelement (6,17) beispielhaft vollständig umgibt, soweit es durch die Darstellungsart der Querschnittsdarstellung der FIG 5 zeichnerisch darstellbar ist.

Eine erste Kontakteinheit (4) auf der ersten Seite (3) der Kontaktierungsvorrichtung (1) ist mit der zweiten Kontakteinheit (7) auf der zweiten Seite (5) der Kontaktierungsvorrichtung (1) mittels einer elektrischen Durchkontaktierung (8) elektrisch verbunden und eine dritte Kontakteinheit (9) auf der ersten Seite (3) der Kontaktierungsvorrichtung (1) ist mit der vierten Kontakteinheit (10) auf der zweiten Seite (5) der Kontaktierungsvorrichtung (1) ebenfalls mittels einer elektrischen Durchkontaktierung (8) elektrisch verbunden.

Ein erstes elektrisches Anschlussmittel (18), welches innerhalb der Abdeckplatte (12) angeordnet ist, verbindet die erste Kontakteinheit (4) elektrisch mit einem hier nicht näher spezifizierten Kontakt des Leistungshalbleiters (2) und ein zweites elektrisches Anschlussmittel (19), welches ebenfalls innerhalb der Abdeckplatte (12) angeordnet ist, verbindet die dritte Kontakteinheit (9) mit einem hier nicht näher spezifizierten weiteren Kontakt des Leistungshalbleiters (2).

## Patentansprüche

1. Kontaktierungsvorrichtung (1) zur elektrischen Kontaktierung eines Leistungshalbleiters (2) mit einem Trägerelement (6), wobei
- die Kontaktierungsvorrichtung (1) derart ausgebildet ist, dass sie den Leistungshalbleiter (2) zumindest teilweise begrenzen kann,
- die Kontaktierungsvorrichtung (1) an einer ersten Seite (3) eine erste Kontakteinheit (4) zur elektrischen Verbindung mit dem Leistungshalbleiter (2) aufweist,
- die Kontaktierungsvorrichtung (1) an einer zweiten Seite (5), welche der ersten Seite (3) abgewandt ist, mit dem Trägerelement (6) mechanisch verbindbar ist,
- die Kontaktierungsvorrichtung (1) eine zweite Kontakteinheit (7) zur elektrischen Verbindung mit dem Trägerelement (6) aufweist und
- die erste Kontakteinheit (4) mit der zweiten Kontakteinheit (7) elektrisch verbunden ist.

2. Kontaktierungsvorrichtung (1) nach Anspruch 1, wobei die zweite Kontakteinheit (7) an der zweiten Seite (5) angeordnet ist und wobei die elektrische Verbindung zwischen der ersten Kontakteinheit (4) und der zweiten Kontakteinheit (7) mittels mindestens einer elektrischen Durchkontaktierung (8) ausgebildet ist.

3. Kontaktierungsvorrichtung (1) nach Anspruch 1, wobei die zweite Kontakteinheit (7) auf der ersten Seite (3) der Kontaktierungsvorrichtung (1) angeordnet ist und wobei die zweite Kontakteinheit (7) mit der ersten Kontakteinheit (4) elektrisch leitend verbunden ist.

4. Kontaktierungsvorrichtung (1) nach einem der vorhergehenden Ansprüche,
wobei
- die Kontaktierungsvorrichtung (1) eine dritte Kontakteinheit (9), welche von der ersten Kontakteinheit (4) elektrisch isoliert ist, zur elektrischen Verbindung mit dem Leistungshalbleiter (2) aufweist,
- die Kontaktierungsvorrichtung (1) eine vierte Kontakteinheit (10), welche von der zweiten Kontakteinheit (7) elektrisch isoliert ist, zur elektrischen Verbindung mit dem Trägerelement (6) aufweist und
- die dritte Kontakteinheit (9) mit der vierten Kontakteinheit (10) elektrisch verbunden ist.

5. Kontaktierungsvorrichtung (1) nach einem der vorhergehenden Ansprüche, wobei die erste Seite (3) der Kontaktierungsvorrichtung (1) zumindest teilweise eine erste Kupferkaschierung (11) zur mechanischen Befestigung mit einer Abdeckplatte (12) aufweist und/ oder die zweite Seite (5) der Kontaktierungsvorrichtung (1) zumindest teilweise eine zweite Kupferkaschierung (13) zur mechanischen Befestigung mit dem Trägerelement (6) aufweist.

6. Kontaktierungsvorrichtung (1) nach einem der vorhergehenden Ansprüche, wobei die Kontaktierungsvorrichtung (1) eine O-Form (OF), eine U-Form (UF), eine L-Form (LF) oder eine I-Form (IF) zur Begrenzung des Leistungshalbleiters (2) von der Kontaktierungsvorrichtung (1) aufweist.

7. Elektronische Baugruppe (14),
aufweisend
- eine Kontaktierungsvorrichtung (1) nach einem der Ansprüche 1 bis 6,
- den Leistungshalbleiter (2) und
- das Trägerelement (6),
wobei
- die Kontaktierungsvorrichtung (1) den Leistungshalbleiter (2) zumindest teilweise begrenzt,
- die Kontaktierungsvorrichtung (1) an der ersten Seite (3) mittels der ersten Kontakteinheit (4) mit dem Leistungshalbleiter (2) elektrisch verbunden ist,
- die Kontaktierungsvorrichtung (1) an der zweiten Seite (5) mit dem Trägerelement (6) mechanisch verbunden ist und
- die Kontaktierungsvorrichtung (1) mittels der zweiten Kontakteinheit (7) mit dem Trägerelement (6) elektrisch verbunden ist.

8. Elektronische Baugruppe (14) nach Anspruch 7 und Anspruch 4, wobei die Kontaktierungsvorrichtung (1) an der ersten Seite (3) mittels der dritten Kontakteinheit (9) mit dem Leistungshalbleiter (2) elektrisch verbunden ist und wobei die Kontaktierungsvorrichtung (1) mittels der vierten Kontakteinheit (10) mit dem Trägerelement (6) elektrisch verbunden ist.

9. Elektronische Baugruppe (14) nach einem der Ansprüche 7 oder 8, und nach Anspruch 5, aufweisend die Abdeckplatte (12), welche mit der ersten Seite (3) der Kontaktierungsvorrichtung (1) zumindest mechanisch verbunden ist.

10. Elektronische Baugruppe nach einem der Ansprüche 7 bis 9, wobei die erste Kontakteinheit (4) mit dem Leistungshalbleiter (2) über die Abdeckplatte (12) mittels eines ersten elektrischen Anschlussmittels (18) elektrisch verbunden ist und/oder wobei, sofern die dritte Kontakteinheit (9) vorhanden ist, die dritte Kontakteinheit (9) mit dem Leistungshalbleiter (2) über die Abdeckplatte (12) mittels eines zweiten elektrischen Anschlussmittels (19) elektrisch verbunden ist.

11. Elektronische Baugruppe (14) nach einem der Ansprüche 7 bis 10, wobei der Leistungshalbleiter (2) entlang der Begrenzung durch die Kontaktierungsvorrichtung (1) in einem unmittelbaren mechanischen Kontakt mit der Kontaktierungsvorrichtung (1) steht.

12. Elektronische Baugruppe (14) nach einem der Ansprüche 7 bis 10, wobei entlang der Begrenzung des Leistungshalbleiters (2) durch die Kontaktierungsvorrichtung
(1) ein Zwischenraum (16) zwischen Kontaktierungsvorrichtung (1) und Leistungshalbleiter (2) gebildet ist und wobei der Zwischenraum (16) vorzugsweise mittels eines thermisch leitfähigen und/oder elektrisch isolierenden Füllstoffs ausgefüllt ist.

13. Elektronische Baugruppe (14) nach einem der Ansprüche 7 bis 12, wobei als Trägerelement (6) ein planes Trägerelement (17) ohne Ausbuchtung und/oder Einbuchtung für den Leistungshalbleiter (2) verwendet wird.

14. Elektronische Baugruppe (14) nach einem der Ansprüche 7 bis 13, wobei die Höhe (HK) der Kontaktierungsvorrichtung (1) zumindest 80% der Höhe (HL) des Leistungshalbleiters (2) entspricht.

15. Serie von elektronischen Baugruppen (14), umfassend ein erstes elektronisches Baugruppenserienelement mit einem Leistungshalbleiter (2) einer ersten geometrischen Dimensionierung und ein zweites elektronisches Baugruppenserienelement mit einem zweiten Leistungshalbleiter (2) einer zweiten geometrischen Dimensionierung,
wobei
- die zweite geometrische Dimensionierung unterschiedlich zur ersten geometrischen Dimensionierung ist,
- das erste elektronische Baugruppenserienelement eine elektronische Baugruppe (14) nach einem der Ansprüche 7 bis 14 umfasst, deren Kontaktierungsvorrichtung (1) an den Leistungshalbleiter (2) der ersten geometrischen Dimensionierung angepasst ist,
- das zweite elektronische Baugruppenserienelement eine elektronische Baugruppe (14) nach einem der Ansprüche 7 bis 14 umfasst, deren Kontaktierungsvorrichtung (1) an den Leistungshalbleiter (2) der zweiten geometrische Dimensionierung angepasst ist und
- für das erste und das zweite elektronische Baugruppenserienelement jeweils als Trägerelement (6) ein planes Trägerelement (17) ohne Ausbuchtung und/oder Einbuchtung für die Leistungshalbleiter (2) verwendet wird.
